# EUROPEAN PATENT SPECIFICATION

(11) **EP 2 639 816 B1**
(45) Date of publication and mention of the grant of the patent: **18.09.2019**
(21) Application number: 12193173.7
(22) Date of filing: 19.11.2012
(51) Int. Cl.: H01L 27/11558, H01L 21/28, G11C 16/04, H01L 21/336, H01L 29/788, H01L 29/423, H01L 27/11529

(54) **Method of fabricating a single-poly floating-gate memory device**
Verfahren zum Herstellen einer Floating-gate-Speichervorrichtung mit einer einzelnen Polysiliziumschicht
Procédé de fabrication d'un dispositif de mémoire à grille flottante ayant une seule couche de polysilicium

(30) Priority: 12.03.2012 US 201261609376 P
(43) Date of publication of application: 18.09.2013
(73) Proprietor: eMemory Technology Inc., Hsin-Chu 30075 (TW)
(72) Inventor: Hsu, Te-Hsun, 310 Hsinchu County (TW); Chen, Hsin-Ming, 300 Hsinchu City (TW); Ching, Wen-Hao, 310 Hsinchu County (TW); Chen, Wei-Ren, 900 Pingtung County (TW)
(74) Representative: Krauns, Christian

(56) References cited:
- US-A1- 2010 149 874
- US-A1- 2010 163 956
- US-A1- 2010 329 016
- US-B1- 6 255 169

## Description

### FIELD OF THE INVENTION

The present invention relates to a nonvolatile memory, and more particularly to a method of fabricating an erasable programmable single-poly nonvolatile memory.

### BACKGROUND OF THE INVENTION

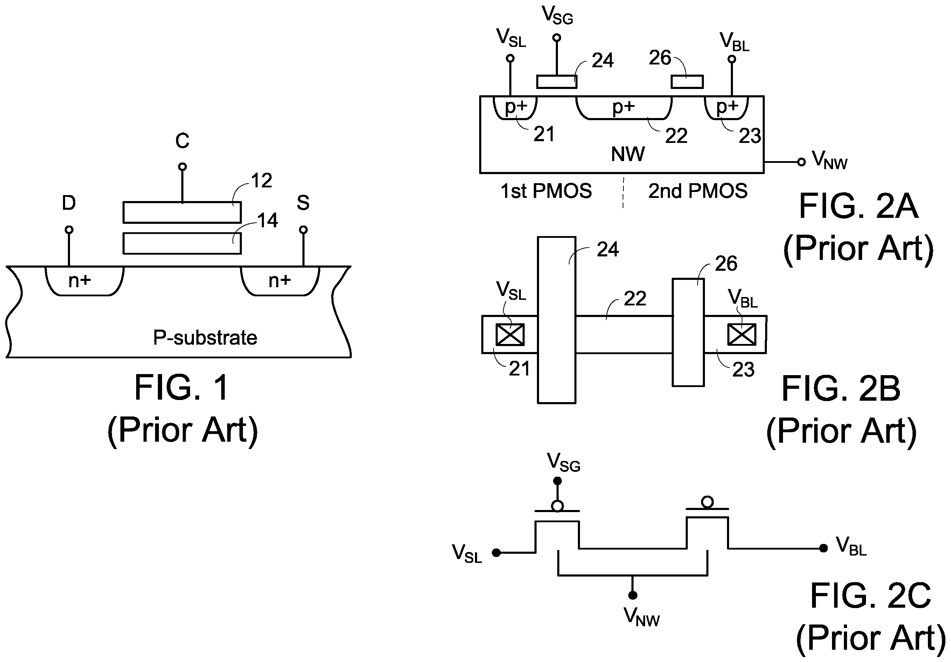

FIG. 1 is a schematic cross-sectional view illustrating a conventional programmable dual-poly nonvolatile memory. The programmable dual-poly nonvolatile memory is also referred as a floating-gate transistor. As shown in FIG. 1, this nonvolatile memory comprises two stacked and separated gates. The upper gate is a control gate 12, which is connected to a control line C. The lower gate is a floating gate 14. In addition, an n-type doped source region and an n-type doped drain region are constructed in a P-substrate. The n-type doped source region is connected to a source line S. The n-type doped drain region is connected to a drain line D.

In a case that the nonvolatile memory is in a programmed state, a high voltage (e.g. +16V) is provided by the drain line D, a ground voltage is provided by the source line S, and a control voltage (e.g. +25V) is provided by the control line C. Consequently, during the electrons are transmitted from the source line S to the drain line D through an n-channel region, the hot carriers (e.g. hot electrons) are attracted by the control voltage on the control gate 12 and injected into the floating gate 14. Under this circumstance, a great number of carriers are accumulated in the floating gate 14. Consequently, the programmed state may be considered as a first storage state (e.g. "0").

In a case that the nonvolatile memory is in a non-programmed state, no carrier is injected into the floating gate 14, and thus the non-programmed state may be considered as a second storage state (e.g. "1").

In other words, the characteristic curves of the drain current (id) and the gate-source voltage (Vgs) (i.e. an id-Vgs characteristic curve) in the first storage state and the id-Vgs characteristic curve in the second storage state are distinguished. Consequently, the storage state of the floating-gate transistor may be realized according to the variation of the id-Vgs characteristic curve.

However, since the floating gate 14 and the control gate 12 of the programmable dual-poly nonvolatile memory should be separately produced, the process of fabricating the programmable dual-poly nonvolatile memory needs more steps and is incompatible with the standard CMOS manufacturing process.

US 2010/0163956 A1 discloses an EEPROM device which have, at the region where the control gate is formed, a gate oxide layer having a relatively smaller thickness than the gate oxide layer of the tunneling region by removing the gate oxide layer, at a predetermined thickness, at the region where the control gate is formed. The integration of an EEPROM device is be maximized as a result of minimizing the area of the control gate.

US 6,255,169 B1 discloses a process for fabricating a non-volatile memory device with the step of forming a nitrogen region in a semiconductor substrate prior to carrying out a thermal oxidation process to form a tunnel oxide layer. Nitrogen atoms are ion implanted into a silicon substrate to form a nitrogen region at the substrate surface. Then, a thermal oxidation process is carried out to grow a thin tunnel oxide layer overlying the surface of the nitrogen region. During the oxidation process, nitrogen is incorporated into the growing tunnel oxide layer. A floating-gate electrode is formed overlying the tunnel oxide layer and receives electrical charge transferred from a charge control region of the substrate through the tunnel oxide layer. The tunnel oxide layer is capable of undergoing repeated programming and erasing operations while exhibiting reduced effects from stress induced current leakage. An MOS transistor having enhanced carrier mobility is obtained by forming a gate oxide layer over a nitrogen region of a silicon substrate. The thermal oxidation process also provides both tunnel oxide layers and gate oxide layers having a reduced thickness for a given set of thermal oxidation conditions.

US patent No. 6678190 discloses a programmable single-poly nonvolatile memory. FIG. 2A is a schematic cross-sectional view illustrating a conventional programmable single-poly nonvolatile memory disclosed in US patent No. 6678190. FIG. 2B is a schematic top view illustrating the conventional programmable single-poly nonvolatile memory of FIG. 2A. FIG. 2C is a schematic circuit diagram illustrating the conventional programmable single-poly nonvolatile memory of FIG. 2A.

Please refer to FIGS. 2A∼2C. The conventional programmable single-poly nonvolatile memory comprises two serially-connected p-type metal-oxide semiconductor (PMOS) transistors. The first PMOS transistor is used as a select transistor, and a select gate 24 of the first PMOS transistor is connected to a select gate voltage V_{SG}. A p-type doped source region 21 is connected to a source line voltage V_{SL}. Moreover, a p-type doped drain region 22 may be considered as a combination of a p-type doped drain region of the first PMOS transistor and a first p-type doped region of the second PMOS transistor. A floating gate 26 is disposed over the second PMOS transistor. A second p-type doped region 23 of the second PMOS transistor is connected to a bit line voltage V_{BL}. Moreover, these PMOS transistors are constructed in an N-well region (NW). The N-well region is connected to an N-well voltage V_{NW}. The second PMOS transistor is used as a floating gate transistor.

By properly controlling the select gate voltage V_{SG}, the source line voltage V_{SL}, the bit line voltage V_{BL} and the N-well voltage V_{NW}, the conventional programmable single-poly nonvolatile memory may be operated in a programmed state or a read state.

Since the two PMOS transistors of the conventional programmable single-poly nonvolatile memory have respective gates 24 and 26, the process of fabricating the conventional programmable single-poly nonvolatile memory is compatible with the standard CMOS manufacturing process.

As described in FIGS. 1 and 2, the nonvolatile memory is programmable. The electrical property of the nonvolatile memory is only utilized to inject a great number of hot carriers to the floating gate. However, the electrical property fails to be utilized to remove the carriers from the floating gate. That is, for achieving the data-erasing function, the carriers stored in the floating gate may be removed from the floating gate by exposing ultraviolet (UV) light to the nonvolatile memory. These nonvolatile memories are named as one time programming (OTP) memories.

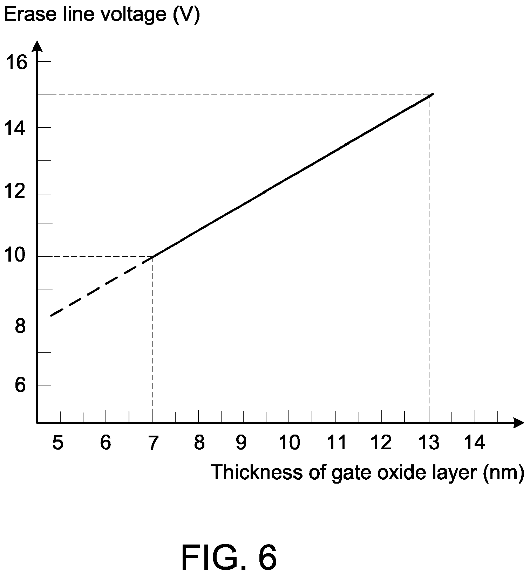

Document US 2010/0149874 A1 discloses an erasable programmable single-poly nonvolatile memory, comprising: a substrate structure (301); a first PMOS transistor (figure 6, 330) comprising a select gate ([0059], figure 8), a first source/drain region (figure 8), and a second source/drain region (312B); a second PMOS transistor (310) comprising the second source/drain region (312B), a third source/drain region (figure 8), and a floating gate (116 in figures 1 - 3, [0035] - [0037], [0057]), and the first source/drain region, the second source/drain region, and the third source/drain region are constructed in a N-well region (302, figure 8); and an erase gate region (figure 6), wherein the floating gate extends over said erase gate region (figure 6), wherein the erase gate region comprises an n-type source/drain region (322B) and a P-well region (303), wherein the N-well region (302) and the P-well region (303) are formed in the substrate structure (figures 6 - 9).

Therefore, for multi-times programming (MTP) memories design, there is a need of providing an erasable programmable single-poly nonvolatile memory.

### SUMMARY OF THE INVENTION

The present invention provides a method of fabricating an erasable programmable single-poly nonvolatile memory in order to obviate the drawbacks encountered from the prior art.

The present invention provides a method of fabricating an erasable programmable single-poly nonvolatile memory according to the independent claim.

Numerous objects, features and advantages of the present invention will be readily apparent upon a reading of the following detailed description of embodiments of the present invention when taken in conjunction with the accompanying drawings. However, the drawings employed herein are for the purpose of descriptions and should not be regarded as limiting.

### BRIEF DESCRIPTION OF THE DRAWINGS

The above objects and advantages of the present invention will become more readily apparent to those ordinarily skilled in the art after reviewing the following detailed description and accompanying drawings, in which:
FIG. 1 (prior art) is a schematic cross-sectional view illustrating a conventional programmable dual-poly nonvolatile memory;
FIG. 2A (prior art) is a schematic cross-sectional view illustrating a conventional programmable single-poly nonvolatile memory disclosed in US patent No. 6678190;
FIG. 2B (prior art) is a schematic top view illustrating the conventional programmable single-poly nonvolatile memory of FIG. 2A;
FIG. 2C (prior art) is a schematic circuit diagram illustrating the conventional programmable single-poly nonvolatile memory of FIG. 2A;
FIGS. 3A~3D schematically illustrate an erasable programmable single-poly nonvolatile memory formed according to an embodiment of the fabrication method of the present invention;
FIGS. 4 illustrates the standard CMOS process for manufacturing the erasable programmable single-poly nonvolatile memory of the present invention;
FIG. 5A∼5H shows the steps of manufacturing the erasable programmable single-poly nonvolatile memory according to the standard CMOS process;
FIG. 6 is a plot illustrating the relation of the thickness of the gate oxide layer and the erase line voltage (V_{EL}).

### DETAILED DESCRIPTION OF PREFERRED EMBODIMENTS

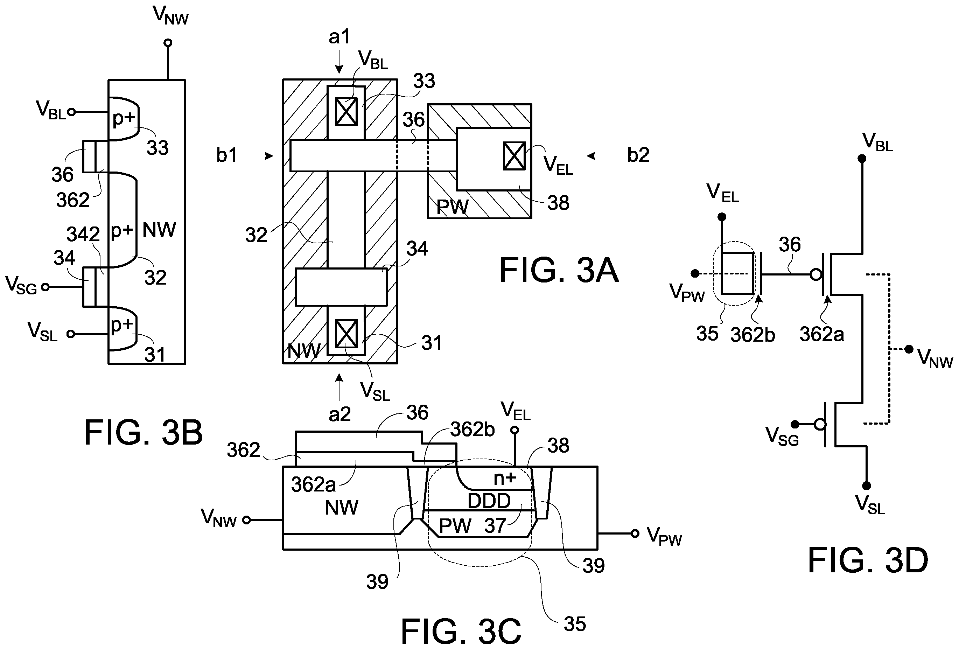

FIGS. 3A∼3D schematically illustrate an erasable programmable single-poly nonvolatile memory formed according to the fabrication method of the present invention. FIG. 3A is a schematic top view illustrating the erasable programmable single-poly nonvolatile memory formed according to the fabrication method of the present invention. FIG. 3B is a schematic cross-sectional view illustrating the erasable programmable single-poly nonvolatile memory of FIG. 3A and taken along a first direction (a1-a2). FIG. 3C is a schematic cross-sectional view illustrating the erasable programmable single-poly nonvolatile memory of FIG. 3A and taken along a second direction (b1-b2). FIG. 3D is a schematic equivalent circuit diagram of the erasable programmable single-poly nonvolatile memory formed according to the fabrication method of the present invention.

As shown in FIGS. 3A and 3B, the erasable programmable single-poly nonvolatile memory formed according to the fabrication method of the present invention comprises two serially-connected p-type metal-oxide semiconductor (PMOS) transistors. These two PMOS transistors are constructed in an N-well region (NW). Three p-type doped regions 31, 32 and 33 are formed in the N-well region (NW). In addition, two polysilicon gates 34 and 36 are spanned over the areas between the three p-type doped regions 31, 32 and 33, and gate oxides layer 342 and 362 are formed between the two polysilicon gates 34 and 36 and a top surface of the substrate.

The first PMOS transistor is used as a select transistor, and the polysilicon gate 34 (also referred as a select gate) of the first PMOS transistor is connected to a select gate voltage V_{SG}. The p-type doped region 31 is a p-type doped source region and connected to a source line voltage V_{SL}. The p-type doped region 32 is a p-type doped drain region, which may be considered as a combination of a p-type doped drain region of the first PMOS transistor and a first p-type doped region of the second PMOS transistor. The polysilicon gate 36 (also referred as a floating gate) is disposed over the second PMOS transistor. The p-type doped region 33 is a second p-type doped region of the second PMOS transistor and connected to a bit line voltage V_{BL}. Moreover, the N-well region (NW) is connected to an N-well voltage V_{NW}. The second PMOS transistor is used as a floating gate transistor.

As shown in FIGS. 3A and 3C, the erasable programmable single-poly nonvolatile memory formed according to the fabrication method of the present invention comprises an n-type metal-oxide semiconductor (NMOS) transistor or a combination of the floating gate 36, gate oxide layer 362 and an erase gate region 35. The NMOS transistor is constructed in a P-well region (PW). A double diffused drain (DDD) region 37 is formed between an n-type doped region 38 and a P-well region (PW). In other words, the erase gate region 35 includes the P-well region (PW), the double diffused drain (DDD) region 37 and the n-type doped regions 38.

As shown in FIG. 3A, the floating gate 36 is extended to and is adjacent to the erase gate region 35. Moreover, a combination of the n-type doped region 38 and the DDD region 37 may be considered as a combination of an n-type doped source region and an n-type doped drain region of the NMOS transistor. The n-type doped region 38 is connected to an erase line voltage V_{EL}. In addition, the P-well region (PW) is connected to a P-well voltage V_{PW}. As shown in FIG. 3C, the gate oxide layer 362 is formed under the floating gate 36, and the gate oxide layer 362 includes two portions 362a and 362b. The first portion 362a of the gate oxide layer 362 is formed in the floating gate transistor (second PMOS transistor) and the second portion 362b of the gate oxide layer 362 is formed in the NMOS transistor (or above the erase gate region 35). According to the present invention, a thickness of the first portion 362a of the gate oxide layer 362 is thicker than a thickness of the second portion 362b of the gate oxide layer 362. Furthermore, a shallow trench isolation (STI) structure 39 is formed between the P-well region (PW) and the N-well region (NW).

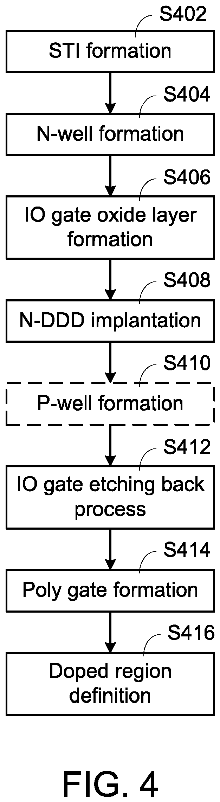

FIGS. 4 illustrates the standard CMOS process for manufacturing the erasable programmable single-poly nonvolatile memory of the present invention. These processes include STI formation (S402), N-well formation (S404), IO gate oxide layer formation (S406), N-DDD implantation (S408), P-well formation (S410), IO gate etching back process (S412), poly gate formation (S414), and doped region definition (S416).

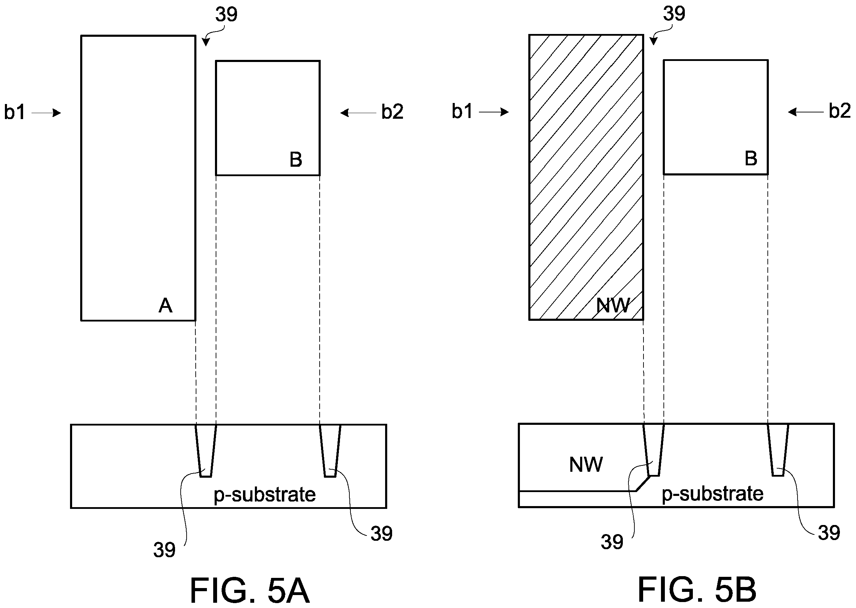

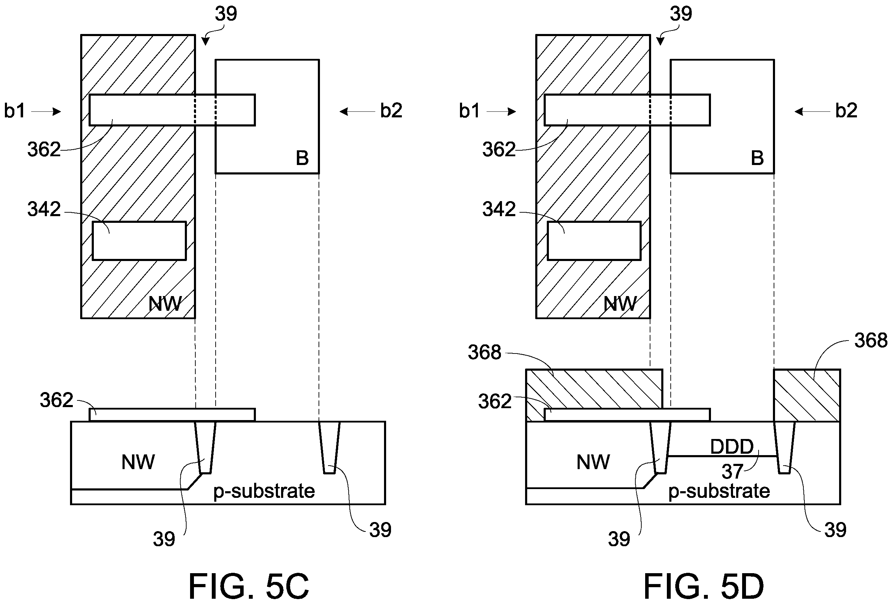

FIG. 5A∼5H shows the steps of manufacturing the erasable programmable single-poly nonvolatile memory according to the standard CMOS process. Because the main feature of the present invention is the erase gate region, only the top view and the cross-sectional view taken along the (b1-b2) direction are shown.

According to the top view in FIG. 5A, two separate areas (A and B) are defined in p-substrate after the STI formation process. According to the cross-sectional view in FIG., 5A, STI structures 39 are embedded in p substrate. According to the present invention, two serially-connected PMOS transistors will be formed in area A and the erase gate region will be formed in area B.

In the N-well formation process, only the area A is exposed and a N-well implantation process is performed. According to the top view and the cross-sectional view in FIG. 5B, an N-well region (NW) is formed in p-substrate.

In the IO gate oxide layer formation process, two gate oxide layers 342 and 362 are formed on the surface of the substrate for two serially-connected PMOS transistors. Furthermore, the gate oxide layer 362 is extended to and is adjacent to the area B.

As shown in FIG. 5D, in the N-DDD implantation step, a mask layer, for example a photoresist (PR) mask layer or a SiN hard mask layer, is formed and only the area B is exposed and the other area is protected by a mask layer. And then, an N-DDD implantation process is performed. According to the cross-sectional view in FIG. 5D, a DDD region 37 is formed in p-substrate after the N-DDD implantation step.

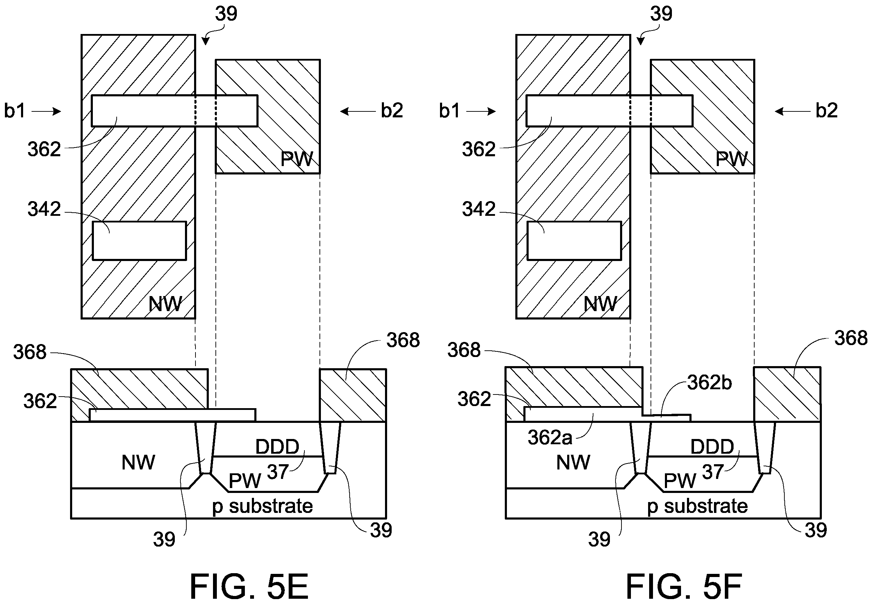

After the N-DDD implantation process, the same mask layer used in the N-DDD implantation step is used again for the P-well formation process. According to the cross-sectional view in FIG. 5E, a P-Well region (PW) is formed under the DDD region 37. Because the p substrate has the same type with the P-well region (PW), the P-well formation process could be optionally performed.

After the P-well formation process, the same mask layer still is used again for the IO gate etching back process. According to the cross-sectional view in FIG. 5F, a first portion 362a of the gate oxide layer 362 protected by the mask layer is not etched and a second portion 362b of the gate oxide layer 362 not protected by the mask layer is etched to have a thinner thickness than the first portion 362a. According to the present invention, a short loop feedback system by monitoring a pattern on the substrate is used to exactly etch the gate oxide layer 362.

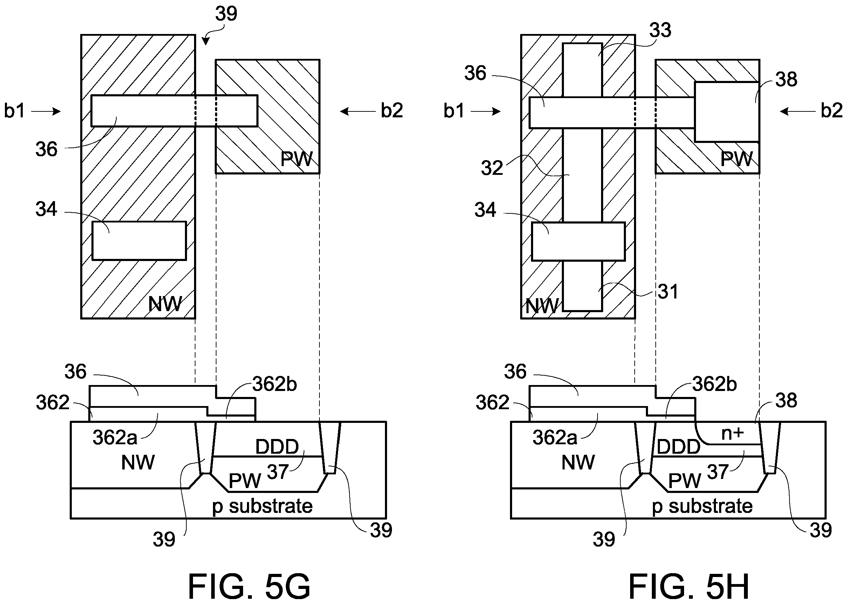

After removing the mask layer 368, a poly gate formation process is proceeded. As shown in FIG. 5G, two polysilicon gates 34 and 36 are covered on the two gate oxide layers 362 and 342 after the poly gate formation process.

In the doped region definition process, a formation of n-type doped region and a formation of p-type doped region are separately performed. As shown in FIG. 5H, an n-type doped region 38 is formed in the DDD region 37 and the erase gate region is formed. Also, three p-type doped region 31 32 and 33 are formed in the NW region and the two serially-connected PMOS transistors are formed. Therefore, the erasable programmable single-poly nonvolatile memory of the present invention is manufactured.

FIG. 6 is a plot illustrating the relation of the thickness of the gate oxide layer and the erase line voltage (V_{EL}). In standard CMOS manufacturing process, thickness of the gate oxide layer 362 of 5V IO device is about 13nm and the erase line voltage (V_{EL}) is about 15-16V to remove the storage carriers from the floating gate 36. However, the higher erase line voltage (V_{EL}) may result in junction breakdown and high ERS power in the erase gate region 35. According to the embodiment of the present invention, a portion (second portion 362b) of the gate oxide layer 362 is further etched to have a thinner thickness (about 7nm) then the first portion 362a. Here, the erase line voltage (V_{EL}) will be about 10V∼11V.

In the programmed state, the hot carriers (e.g. electrons) are transmitted through a channel region of the floating gate transistor corresponding to the floating gate 36, the first portion 362a of gate oxide layer 362 are tunneled by the hot electrons and then the hot electrons are injected into the floating gate 36. In the erased state, the second portion 362b of gate oxide layer 362 are tunneled by the storage carriers in the floating gate 36 and then the storage carriers are discharged out of the nonvolatile memory through the n-type doped region 38 and the DDD region 37. That is to say, a thickness of the first portion 362a for the hot electrons injected into the floating gate 36 is thicker than a thickness of the second portion 362b for storage carriers ejected from the gate oxide 36.

From the above description, the erasable programmable single-poly nonvolatile memory formed according to the fabrication method of the present invention is capable of decreasing the erase line voltage (V_{EL}). That is, by providing a lower erase line voltage V_{EL}, storage state of the nonvolatile memory of the present invention is changed.

## Claims

1. A method of fabricating an erasable programmable single-poly nonvolatile memory, comprising the following sequence of steps:
(S402) defining a first area (A) and a second area (B) in a first conductivity type substrate;
(S404) forming a second conductivity type well region (NW) only in the first area (A);
(S406) forming a first gate oxide layer (342) and a second gate oxide layer (362) on a surface of the first area (A), wherein the second gate oxide layer (362) is extended over the second area (B);
(S408) forming a second conductivity type double diffused drain region (37) only in the second area (B);
(S410) forming a first conductivity type well region (PW) only in the second area (B), wherein the first conductivity type well region (PW) is formed under the second conductivity type double diffused drain region (37);
(S412) processing the second gate oxide layer (362) to form a first portion (362a) of the second gate oxide layer (362) directly connected with a second portion (362b) of the second gate oxide layer (362), wherein a thickness of the first portion (362a) of the second gate oxide layer (362) above the first area (A) is thicker than a thickness of the second portion (362b) of the second gate oxide layer (362) above the second area (B);
(S414) forming a first polysilicon gate (34) and a second polysilicon gate (36), respectively on the first gate oxide layer (342) and the second gate oxide layers (362) for manufacturing a select transistor and a floating gate transistor in the first area (A), wherein the first polysilicon gate (34) is a gate of said select transistor and the second polysilicon gate (36) is a floating gate of said floating gate transistor; and
(S416) forming a second conductivity type doped region (38) in said second conductivity type double diffused drain region (37) in the second area (B) and forming first conductivity type doped regions (31, 32, 33) in the second conductivity type well region (NW) so as to manufacture said select transistor and said floating gate transistor connected in series when the formation of said first conductivity type doped regions (31, 32, 33) is completed.

2. The method as claimed in claim 1, wherein the first conductivity type is p-type and the second conductivity type is n-type.

3. The method as claimed in claim 1 to 2, wherein a plurality of shallow trench isolation structures (39) are formed and embedded in the first conductivity type substrate to define the first area (A) and the second area (B).

## Patentansprüche

1. Verfahren zum Herstellen eines löschbaren programmierbaren nichtflüchtigen Einzelpolyspeichers, welches die folgende Abfolge von Schritten umfasst:
(S402) ein Bestimmen eines ersten Bereichs (A) und eines zweiten Bereichs (B) in einem Substrat vom Typ einer ersten Leitfähigkeit,
(S404) ein Bilden eines Wannenbereichs (NW) vom Typ einer zweiten Leitfähigkeit nur in dem ersten Bereich (A),
(S406) ein Bilden einer ersten Gatteroxidschicht (342) und einer zweiten Gatteroxidschicht (362), die auf einer Oberfläche des ersten Bereichs (A) bedeckt sind, wobei sich die zweite Gatteroxidschicht (362) über den zweiten Bereich (B) erstreckt,
(S408) ein Bilden eines doppelt diffundierten Senkenbereichs (37) vom Typ der zweiten Leitfähigkeit nur in dem zweiten Bereich (B),
(S410) ein Bilden eines Wannenbereichs (PW) vom Typ der ersten Leitfähigkeit nur in dem zweiten Bereich (B), wobei der Wannenbereich (PW) vom Typ der ersten Leitfähigkeit unter dem doppelt diffundierten Senkenbereichs (37) vom Typ der zweiten Leitfähigkeit gebildet worden ist,
(S412) ein Bearbeiten der zweiten Gatteroxidschicht (362), um einen ersten Abschnitt (362a) der zweiten Gatteroxidschicht (362) zu bilden, der direkt mit einem zweiten Abschnitt (362b) der zweiten Gatteroxidschicht (362) verbunden ist, wobei eine Dicke des ersten Abschnitts (362a) der zweiten Gatteroxidschicht (362) über dem ersten Bereich (A) dicker als eine Dicke des zweiten Abschnitts (362b) der zweiten Gatteroxidschicht (362) über dem zweiten Bereich (B) ist,
(S414) ein Bilden eines ersten Polysiliziumgatters (34) und eines zweiten Polysiliziumgatters (36) auf der ersten Gatteroxidschicht (342) bzw. der zweiten Gatteroxidschicht (362), um einen Auswahltransistor und einen Transistor mit einem schwebendem Gatter in den ersten Bereich (A) herzustellen, wobei das erste Polysiliziumgatter (34) ein Gatter des Auswahltransistors ist und das zweite Polysiliziumgatter (36) ein schwebendes Gatter des Transistors mit dem schwebendem Gatter ist, und
(S416) ein Bilden eines dotierten Bereichs (38) vom Typ der zweiten Leitfähigkeit in dem doppelt diffundierten Senkenbereich (37) vom Typ der zweiten Leitfähigkeit in dem zweiten Bereich (B) und ein Bilden von dotierten Bereichen (31, 32, 33) vom Typ der ersten Leitfähigkeit in dem Wannenbereich (NW) vom Typ der zweiten Leitfähigkeit, um den Auswahltransistor und den Transistor mit dem schwebendem Gatter herzustellen, die in Reihe geschaltet sind, wenn die Bildung der dotierten Bereiche (31, 32, 33) vom Typ der ersten Leitfähigkeit abgeschlossen ist.

2. Verfahren nach Anspruch 1, **dadurch gekennzeichnet, dass** der Typ der ersten Leitfähigkeit der p-Typ und der Typ der zweiten Leitfähigkeit der n-Typ ist.

3. Verfahren nach Anspruch 1 bis 2, wobei eine Vielzahl an flachen Grabenisolationsstrukturen (39) gebildet werden und in das Substrat des ersten Leitfähigkeitstyps eingebettet werden, um den ersten Bereich (A) und den zweiten Bereich (B) zu bestimmen.

## Revendications

1. Procédé de fabrication d'une mémoire non volatile programmable effaçable ayant une seule couche de polysilicium, comprenant la séquence suivante d'étapes :
(S402) définir une première zone (A) et une seconde zone (B) dans un substrat de premier type de conductivité ;
(S404) former une région de puits de second type de conductivité (NW) uniquement dans la première zone (A) ;
(S406) former une première couche d'oxyde de grille (342) et une seconde couche d'oxyde de grille (362) sur une surface de la première zone (A), dans lequel la seconde couche d'oxyde de grille (362) est étendue sur la seconde zone (B) ;
(S408) former une région de drain à double diffusion de second type de conductivité (37) uniquement dans la seconde zone (B) ;
(S410) former une région de puits de premier type de conductivité (PW) uniquement dans la seconde zone (B), dans lequel la région de puits de premier type de conductivité (PW) est formée au-dessous de la région de drain à double diffusion de second type de conductivité (37) ;
(S412) traiter la seconde couche d'oxyde de grille (362) pour former une première partie (362a) de la seconde couche d'oxyde de grille (362) directement connectée à une seconde partie (362b) de la seconde couche d'oxyde de grille (362), dans lequel une épaisseur de la première partie (362a) de la seconde couche d'oxyde de grille (362) au-dessus de la première zone (A) est plus épaisse qu'une épaisseur de la seconde partie (362b) de la seconde couche d'oxyde de grille (362) au-dessus de la seconde zone (B) ;
(S414) former une première grille en polysilicium (34) et une seconde grille en polysilicium (36), respectivement sur la première couche d'oxyde de grille (342) et la seconde couche d'oxyde de grille (362) pour fabriquer un transistor de sélection et d'un transistor à grille flottante dans la première zone (A), dans lequel la première grille en polysilicium (34) est une grille dudit transistor de sélection et la seconde grille en polysilicium (36) est une grille flottante dudit transistor à grille flottante ; et
(S416) former une région dopée de second type de conductivité (38) dans ladite région de drain à double diffusion de second type de conductivité (37) dans la seconde zone (B) et former des régions dopées de premier type de conductivité (31, 32, 33) dans la région de puits de second type de conductivité (NW) afin de fabriquer ledit transistor de sélection et ledit transistor à grille flottante connectés en série lorsque la formation desdites régions dopées de premier type de conductivité (31, 32, 33) est achevée.

2. Procédé selon la revendication 1, dans lequel le premier type de conductivité est de type p et le second type de conductivité est de type n.

3. Procédé selon la revendication 1 à 2, dans lequel une pluralité de structures d'isolation par tranchée peu profonde (39) sont formées et incorporées dans le substrat de premier type de conductivité pour définir la première zone (A) et la seconde zone (B).
